# EUROPÄISCHE PATENTANMELDUNG

(11) **EP 3 764 753 A1**
(43) Veröffentlichungstag der Anmeldung: **13.01.2021**
(21) Anmeldenummer: 20184931.2
(22) Anmeldetag: 09.07.2020
(51) Int. Cl.: H05K 1/02, H05K 1/05

(54) **VERFAHREN ZUM BEARBEITEN EINER SCHALTUNGSTRÄGERPLATTE UND SCHALTUNGSTRÄGERPLATTE**

(30) Priorität: 10.07.2019 DE 102019118688
(71) Anmelder: Marelli Automotive Lighting Reutlingen (Germany) GmbH, 72762 Reutlingen (DE)
(72) Erfinder: Schöning, Michael, 37154 Northeim (DE)
(74) Vertreter: DREISS Patentanwälte PartG mbB

(57) **Zusammenfassung**

Verfahren zum Bearbeiten einer Schaltungsträgerplatte (100), aufweisend die folgenden Schritte: Bereitstellen einer Schaltungsträgerplatte, die eine metallische Trägerschicht (110), eine auf einer ersten Oberfläche der metallischen Trägerschicht angeordnete dielektrische Schicht (120) und eine zumindest bereichsweise auf einer ersten Oberfläche der dielektrischen Schicht angeordnete metallische Funktionsschicht (130) aufweist, Biegen wenigstens eines ersten Teilbereichs der Schaltungsträgerplatte (100_1, 100_2).

## Beschreibung

Die Offenbarung betrifft ein Verfahren zum Bearbeiten einer Schaltungsträgerplatte.

Die Offenbarung betrifft ferner eine Schaltungsträgerplatte.

Bevorzugte Ausführungsformen beziehen sich auf ein Verfahren zum Bearbeiten einer Schaltungsträgerplatte, aufweisend die folgenden Schritte: Bereitstellen einer Schaltungsträgerplatte, die eine metallische Trägerschicht, eine auf einer ersten Oberfläche der metallischen Trägerschicht angeordnete dielektrische Schicht und eine zumindest bereichsweise auf einer ersten Oberfläche der dielektrischen Schicht angeordnete metallische Funktionsschicht aufweist, Biegen wenigstens eines ersten Teilbereichs der Schaltungsträgerplatte. Dadurch kann vorteilhaft eine beispielsweise zunächst eben ausgebildete Schaltungsträgerplatte mit dem genannten Schichtaufbau aus z.B. der metallischen Trägerschicht, der dielektrischen Schicht und der metallischen Funktionsschicht in eine gebogene, also nichtebene, Konfiguration überführt werden, wodurch weitere Freiheitsgrade für die Anwendung der Schaltungsträgerplatte z.B. in einer elektronischen Vorrichtung wie beispielsweise einer Beleuchtungseinrichtung für Kraftfahrzeuge erhalten werden.

Bei weiteren bevorzugten Ausführungsformen ist vorgesehen, dass das Biegen des wenigstens einen ersten Teilbereichs entlang einer ersten Biegelinie erfolgt, die bevorzugt einen Abschnitt einer virtuellen Geraden darstellt. Weiter bevorzugt erfolgt das Biegen des wenigstens einen ersten Teilbereichs relativ zu wenigstens einem weiteren Teilbereich der Schaltungsträgerplatte, wobei die erste Biegelinie als Grenze zwischen dem ersten Teilbereich und dem zweiten Teilbereich aufgefasst werden kann.

Mit anderen Worten kann das Biegen entlang der ersten Biegelinie bei weiteren bevorzugten Ausführungsformen zumindest näherungsweise auch als das Rotieren des ersten Teilbereichs der Schaltungsträgerplatte relativ zu dem zweiten Teilbereich der Schaltungsträgerplatte angesehen werden (mit der ersten Biegelinie als Rotationsachse), wobei im Bereich der ersten Biegelinie bevorzugt eine plastische Verformung des Materials der Schaltungsträgerplatte, vorzugsweise der genannten drei Schichten (oder wenigstens der Trägerschicht), eintritt, so dass nach einem Entfernen von für das Biegen genutzten externen Kräften (aufgebracht z.B. durch ein Biegewerkzeug) die Schaltungsträgerplatte in der gebogenen, nichtebenen Konfiguration verbleibt.
Bei weiteren bevorzugten Ausführungsformen ist vorgesehen, dass zumindest ein teilweises Bestücken der Schaltungsträgerplatte vor dem Biegen des wenigstens einen ersten Teilbereichs erfolgt. Dies bedeutet, dass bei weiteren bevorzugten Ausführungsformen eine bereits zumindest teilweise bestückte Schaltungsträgerplatte gebogen wird.

Bei weiteren bevorzugten Ausführungsformen ist vorgesehen, dass das Bestücken wenigstens eines der folgenden Elemente aufweist: a) Setzen von wenigstens einer Komponente, insbesondere wenigstens eines elektrischen oder elektronischen Bauteils, b) Löten von wenigstens einer Komponente, insbesondere wenigstens eines elektrischen oder elektronischen Bauteils, auf die metallische Funktionsschicht.

Alternativ oder ergänzend kann das Setzen und/oder Löten gemäß weiteren bevorzugten Ausführungsformen auch auf mechanische Bauteile wie Kühlkörper, Abstandsbolzen, Steckverbinder bzw. elektromechanische Bauteile angewandt werden.

Bei weiteren bevorzugten Ausführungsformen kann das Bereitstellen der Schaltungsträgerplatte auch das Bereitstellen einer zumindest teilweise bestückten Schaltungsträgerplatte aufweisen. Beispielsweise kann eine noch in ihrer ebenen Konfiguration befindliche Schaltungsträgerplatte mit einer ersten Gruppe von Bauelementen bzw. Komponenten bestückt werden, wobei z.B. auch Lötverfahren wie z.B. Reflow-Löten und dergleichen angewandt werden können. Sodann kann die teilweise bestückte Schaltungsträgerplatte gemäß weiteren bevorzugten Ausführungsformen gebogen werden.
Bei weiteren bevorzugten Ausführungsformen ist vorgesehen, dass das Verfahren weiter aufweist: zumindest teilweises Bestücken der Schaltungsträgerplatte nach dem Biegen des wenigstens einen ersten Teilbereichs. Mit anderen Worten kann ein zumindest teilweises Bestücken, insbesondere Setzen und/oder Löten, der Schaltungsträgerplatte bei weiteren bevorzugten Ausführungsformen auch noch in ihrem gebogenen Zustand ausgeführt werden.

Bei weiteren bevorzugten Ausführungsformen ist vorgesehen, dass das Verfahren weiter aufweist: Definieren wenigstens eines ersten Bereichs, der, insbesondere zumindest vor dem Biegen des wenigstens einen ersten Teilbereichs, nicht bestückt, insbesondere frei gelassen, werden soll. D.h., auf dem ersten Bereich werden keine Bauteile gesetzt bzw. verlötet, insbesondere nicht vor dem Biegen. Dadurch kann vorteilhaft ein Bereich der Schaltungsträgerplatte angegeben werden, in dem die für das Biegen erforderlichen Kräfte eingeleitet werden können, z.B. mittels eines Biegewerkzeugs. Bevorzugt werden die für das Biegen erforderlichen Kräfte direkt in die Schaltungsträgerplatte eingeleitet, wobei ein Kraftfluss z.B. von einem entsprechenden Werkzeug in eine Oberfläche der Trägerschicht und/oder eine Oberfläche der metallischen Funktionsschicht erfolgt (alternativ oder Ergänzend können bei weiteren bevorzugten Ausführungsformen Biegekräfte auch in ein oder mehrere Seitenflächen des durch die Schaltungsträgerplatte gebildeten Schichtstapels eingeleitet werden).

Bei weiteren bevorzugten Ausführungsformen ist vorgesehen, dass das Biegen so erfolgt, dass - bezogen auf die metallische Funktionsschicht - a) der erste Teilbereich einen Winkel ("Biegewinkel") kleiner 180 Grad mit dem zweiten Teilbereich einschließt, mithin sich entsprechende Oberflächenbereiche des ersten Teilbereichs und des zweiten Teilbereichs der metallischen Funktionsschicht einander annähern, oder b) der erste Teilbereich einen Winkel größer 180 Grad mit dem zweiten Teilbereich einschließt, mithin sich entsprechende Oberflächenbereiche des ersten Teilbereichs und des zweiten Teilbereichs der metallischen Funktionsschicht voneinander entfernen.

Bei weiteren bevorzugten Ausführungsformen ist vorgesehen, dass das Biegen bei Normaltemperatur bzw. Raumtemperatur ausgeführt wird.

Bei weiteren bevorzugten Ausführungsformen ist vorgesehen, dass das Biegen mittels Freibiegen ausgeführt wird.

Bei weiteren bevorzugten Ausführungsformen ist vorgesehen, dass das Biegen mittels Gesenkbiegen bzw. Abkanten ausgeführt wird.

Bei weiteren bevorzugten Ausführungsformen ist vorgesehen, dass die metallische Trägerschicht ein Nichteisenmetall oder eine Nichteisenmetall-Legierung aufweist, insbesondere Aluminium. Dadurch ist eine gute Wärmeleitfähigkeit der Trägerschicht gegeben, und die betreffenden Materialien sind effizient plastisch verformbar, so dass die Schaltungsträgerplatte ihre gebogene Konfiguration auch unter Abwesenheit äußerer Kräfte beibehält.

Bei weiteren bevorzugten Ausführungsformen ist vorgesehen, dass die metallische Funktionsschicht Kupfer aufweist, insbesondere Walzkupfer (englisch: rolled annealed copper, "RA copper"), das gut biegbar ist. Walzkupfer-Material ist insbesondere auch vergleichsweise gut dehnbar, wodurch bei weiteren bevorzugten Ausführungsformen Funktionsstrukturen beispielsweise auch im Bereich der Biegelinie bei Biegewinkeln > 180 ° bereitstellbar sind.

Bei weiteren bevorzugten Ausführungsformen ist vorgesehen, dass die metallische Funktionsschicht zumindest bereichsweise strukturiert ist, wodurch z.B. elektrische Leiterbahnen zur Aufnahme und/oder elektrischen Verbindung von elektrischen und/oder elektronischen Bauteilen bereitgestellt werden können.

Bei weiteren bevorzugten Ausführungsformen ist vorgesehen, dass das Biegen weiter aufweist: Biegen wenigstens eines dritten Teilbereichs der Schaltungsträgerplatte, insbesondere entlang einer zweiten Biegelinie relativ zu dem ersten Teilbereich und/oder zu dem wenigstens einen weiteren Teilbereich der Schaltungsträgerplatte. Dadurch sind noch weitere Freiheitsgrade zur Bereitstellung monolithischer nichtebener Schaltungsträgerplatten gegeben.

Bei weiteren bevorzugten Ausführungsformen ist vorgesehen, dass die zweite Biegelinien parallel zu der ersten Biegelinie ist, wodurch sich z.B. i.w. U-förmige bzw. Z-förmige nichtebene Schaltungsträgerplatten bereitstellen lassen.

Bei weiteren bevorzugten Ausführungsformen ist vorgesehen, dass die zweite Biegelinien nicht parallel ist zu der ersten Biegelinie, wodurch sich noch weitere Ausgestaltungen nichtebener Schaltungsträgerplatten bereitstellen lassen.

Weitere bevorzugte Ausführungsformen beziehen sich auf eine Schaltungsträgerplatte mit einer metallischen Trägerschicht, einer auf einer ersten Oberfläche der metallischen Trägerschicht angeordneten dielektrischen Schicht, und einer zumindest bereichsweise auf einer ersten Oberfläche der dielektrischen Schicht angeordneten metallischen Funktionsschicht, wobei wenigstens ein erster Teilbereich der Schaltungsträgerplatte gebogen ist, insbesondere relativ zu wenigstens einem weiteren Teilbereich der Schaltungsträgerplatte entlang einer ersten Biegelinie gebogen.

Bei weiteren bevorzugten Ausführungsformen ist vorgesehen, dass die metallische Trägerschicht ein Nichteisenmetall oder eine Nichteisenmetall-Legierung aufweist, insbesondere Aluminium, und/oder dass die metallische Funktionsschicht Kupfer aufweist, insbesondere Walzkupfer.

Bei weiteren bevorzugten Ausführungsformen ist vorgesehen, dass mehr als ein Teilbereich gegenüber wenigstens einem anderen Teilbereich der Schaltungsträgerplatte gebogen ist. Bei weiteren bevorzugten Ausführungsformen ist vorgesehen, dass die metallische Funktionsschicht im Bereich der ersten Biegelinie zumindest teilweise entfernt ist. Dies kann bei weiteren bevorzugten Ausführungsformen beispielsweise bei dem Bereitstellen der Schaltungsträgerplatte und/oder einem ggf. vorangehenden Schritt des Strukturierens der metallischen Funktionsschicht erfolgen.

Weitere bevorzugte Ausführungsformen beziehen sich auf eine Verwendung wenigstens einer Schaltungsträgerplatte gemäß den Ausführungsformen zur Halterung und/oder elektrischen Verbindung und/oder Entwärmung wenigstens eines Halbleiterbauelements, insbesondere eines optoelektronischen Bauelements, weiter insbesondere einer Leuchtdiode oder Laserdiode.

Weitere Merkmale, Anwendungsmöglichkeiten und Vorteile weiterer bevorzugter Ausführungsformen ergeben sich aus der nachfolgenden Beschreibung und den Figuren der Zeichnung. Dabei bilden alle beschriebenen und dargestellten Merkmale für sich oder in beliebiger Kombination den Gegenstand der Erfindung, unabhängig von den Patentansprüchen oder deren Rückbeziehung sowie unabhängig von Ihrer Formulierung bzw. Darstellung in der Beschreibung bzw. in der Zeichnung.

In der Zeichnung zeigt:
- Fig. 1: schematisch eine Seitenansicht einer Schaltungsträgerplatte gemäß bevorzugten Ausführungsformen,
- Fig. 2: schematisch eine Draufsicht auf die Schaltungsträgerplatte gemäß Fig. 1,
- Fig. 3A: schematisch eine Seitenansicht der Schaltungsträgerplatte gemäß Fig. 1 mit einem Werkzeug in einem ersten Zustand,
- Fig. 3B: schematisch eine Seitenansicht der Schaltungsträgerplatte gemäß Fig. 1 mit einem Werkzeug in einem zweiten Zustand,
- Fig. 4A: schematisch ein vereinfachtes Flussdiagramm eines Verfahrens gemäß weiteren bevorzugten Ausführungsformen,
- Fig. 4B: schematisch ein vereinfachtes Flussdiagramm eines Verfahrens gemäß weiteren bevorzugten Ausführungsformen,
- Fig. 4C: schematisch ein vereinfachtes Flussdiagramm eines Verfahrens gemäß weiteren bevorzugten Ausführungsformen,
- Fig. 4D: schematisch ein vereinfachtes Flussdiagramm eines Verfahrens gemäß weiteren bevorzugten Ausführungsformen,
- Fig. 5: schematisch eine Seitenansicht einer Schaltungsträgerplatte gemäß weiteren bevorzugten Ausführungsformen,
- Fig. 6: schematisch eine Seitenansicht einer Schaltungsträgerplatte gemäß weiteren bevorzugten Ausführungsformen,
- Fig. 7A: eine Seitenansicht einer Schaltungsträgerplatte gemäß weiteren bevorzugten Ausführungsformen,
- Fig. 7B: schematisch eine Draufsicht auf die Schaltungsträgerplatte gemäß Fig. 7B,
- Fig. 8: schematisch eine Seitenansicht einer Schaltungsträgerplatte gemäß weiteren bevorzugten Ausführungsformen, und
- Fig. 9: schematisch eine Draufsicht auf eine Schaltungsträgerplatte gemäß weiteren bevorzugten Ausführungsformen.

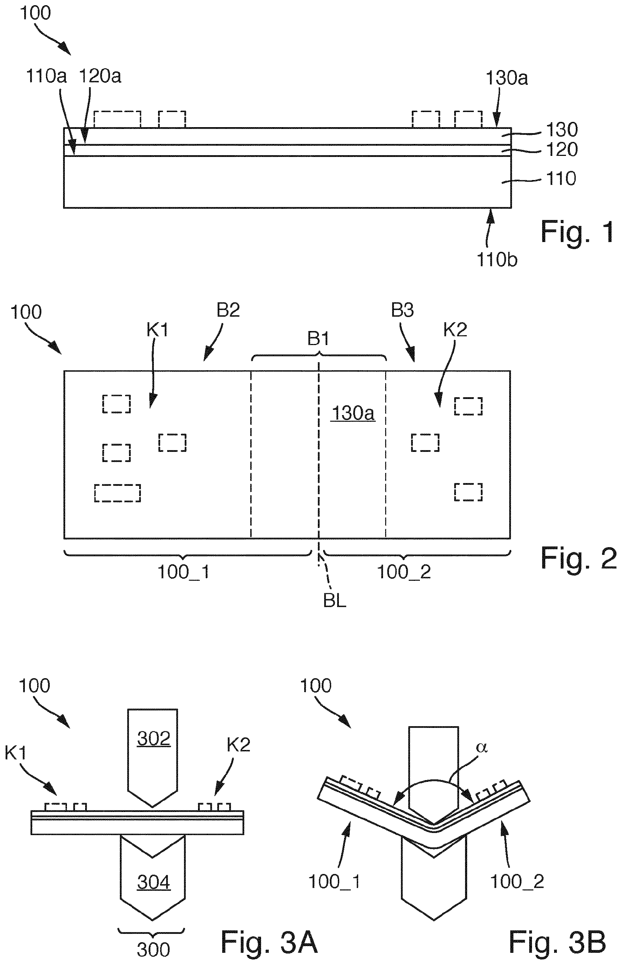

Figur 1 zeigt schematisch eine Seitenansicht einer Schaltungsträgerplatte 100 gemäß bevorzugten Ausführungsformen. Die Schaltungsträgerplatte 100 weist eine metallische Trägerschicht 110 auf, eine auf einer ersten Oberfläche 110a der metallischen Trägerschicht 110 angeordnete dielektrische Schicht 120, und eine zumindest bereichsweise auf einer ersten Oberfläche 120a der dielektrischen Schicht 120 angeordnete metallische Funktionsschicht 130.

Bei weiteren bevorzugten Ausführungsformen ist vorgesehen, dass die metallische Trägerschicht 110 ein Nichteisenmetall oder eine Nichteisenmetall-Legierung aufweist, insbesondere Aluminium.

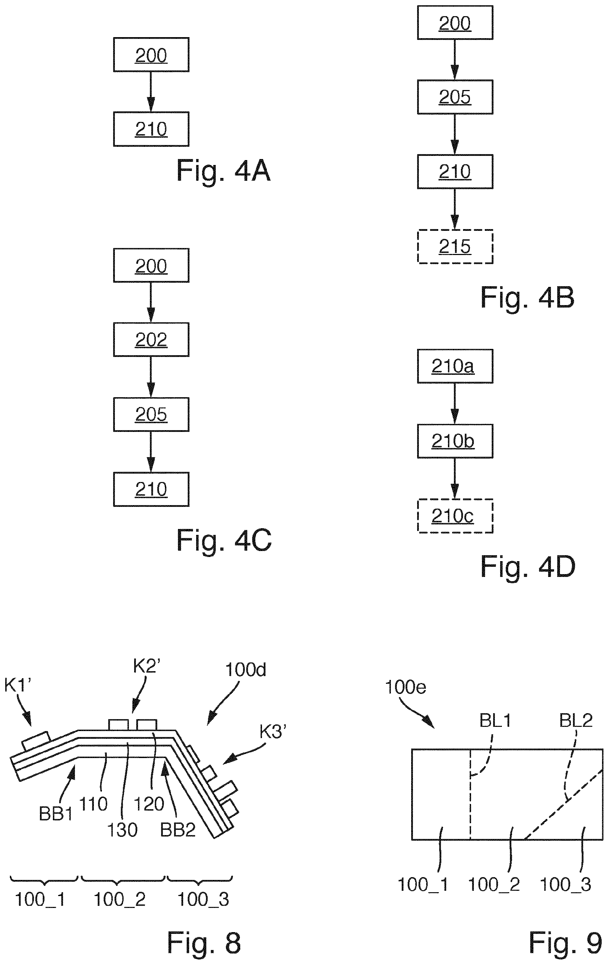

Bei weiteren bevorzugten Ausführungsformen ist vorgesehen, dass die metallische Trägerschicht 110, insbesondere in einem Bereich B1 (s. z.B. Fig. 2), in dem sie bei beispielhaften Ausführungsformen gebogen wird (vgl. Schritt 210 aus Fig. 4A), in einem ebenen (also z.B. nicht bereits gebogenen) Zustand, eine konstante Dicke aufweist.

Bei weiteren bevorzugten Ausführungsformen ist vorgesehen, dass die dielektrische Schicht 120 wenigstens ein Material aufweist, das eine Mischung aus Polymer(en) und Keramikmaterial, insbesondere als Füllmaterial, ist. Durch eine entsprechende Auswahl der Materialanteile von Polymer(en) und Keramikmaterial kann bei weiteren bevorzugten Ausführungsformen z.B. die Haftung und/oder thermische Leitfähigkeit der dielektrischen Schicht 120 beeinflusst, insbesondere auf einen vorgebbaren Bereich bzw. Wert, eingestellt werden.

Bei weiteren bevorzugten Ausführungsformen ist vorgesehen, dass die metallische Funktionsschicht 130 Kupfer aufweist, insbesondere Walzkupfer (englisch: rolled annealed copper).

Bei weiteren bevorzugten Ausführungsformen ist vorgesehen, dass die metallische Funktionsschicht 130 zumindest bereichsweise strukturiert ist, wodurch z.B. elektrische Leiterbahnen zur Aufnahme und/oder elektrischen Verbindung von elektrischen und/oder elektronischen Bauteilen bereitgestellt werden können. Optional kann die Schaltungsträgerplatte 100 zumindest teilweise bestückt sein, vgl. die in Fig. 1 nicht bezeichneten gestrichelten Rechtecke auf der Oberfläche 130a der metallischen Funktionsschicht 130.

Weitere bevorzugte Ausführungsformen sehen vor, dass wenigstens ein erster Teilbereich 100_1 der Schaltungsträgerplatte 100, vgl. die Draufsicht aus Fig. 2, gebogen ist, insbesondere relativ zu wenigstens einem weiteren Teilbereich 100_2 der Schaltungsträgerplatte 100, entlang einer ersten Biegelinie BL gebogen. Dies kann gemäß weiteren bevorzugten Ausführungsformen ausgehend von der in den Figuren 1, 2 gezeigten ebenen Konfiguration der Schaltungsträgerplatte 100 durch das nachfolgend unter Bezugnahme u.a. auf Fig. 4A beschriebene Verfahren erreicht werden.

Bevorzugte Ausführungsformen des genannten Verfahrens, vgl. das Flussdiagramm aus Fig. 4A, weisen die folgenden Schritte auf: Bereitstellen 200 einer Schaltungsträgerplatte 100, die eine metallische Trägerschicht 110, eine auf einer ersten Oberfläche 110a der metallischen Trägerschicht 110 angeordnete dielektrische Schicht 120 und eine zumindest bereichsweise auf einer ersten Oberfläche 120a der dielektrischen Schicht 120 angeordnete metallische Funktionsschicht 130 aufweist (also z.B. eine Schaltungsträgerplatte 100 gemäß Figur 1), Biegen 210 (Fig. 4A) wenigstens eines ersten Teilbereichs 110_1 (Fig. 2) der Schaltungsträgerplatte 100. Dadurch kann vorteilhaft die beispielsweise zunächst eben ausgebildete Schaltungsträgerplatte 100 (Fig. 1, 2) mit dem genannten Schichtaufbau 110, 120, 130 in eine gebogene, also nichtebene, Konfiguration überführt werden, wodurch weitere Freiheitsgrade für die Anwendung der Schaltungsträgerplatte 100 z.B. in einer elektronischen Vorrichtung wie beispielsweise einer Beleuchtungseinrichtung für Kraftfahrzeuge erhalten werden.

Bei weiteren bevorzugten Ausführungsformen ist vorgesehen, dass das Biegen 210 des wenigstens einen ersten Teilbereichs 100_1 (Fig. 2) entlang einer ersten Biegelinie BL erfolgt, die bevorzugt einen Abschnitt einer virtuellen Geraden darstellt. Weiter bevorzugt erfolgt das Biegen 210 des wenigstens einen ersten Teilbereichs 100_1 relativ zu wenigstens einem weiteren Teilbereich 100_2 der Schaltungsträgerplatte 100, wobei die erste Biegelinie BL als Grenze zwischen dem ersten Teilbereich 100_1 und dem zweiten Teilbereich 100_2 aufgefasst werden kann.

Mit anderen Worten kann das Biegen 210 entlang der ersten Biegelinie BL bei weiteren bevorzugten Ausführungsformen zumindest näherungsweise auch als das Rotieren des ersten Teilbereichs 100_1 der Schaltungsträgerplatte 100 relativ zu dem zweiten Teilbereich 100_2 der Schaltungsträgerplatte 100 angesehen werden (mit der ersten Biegelinie BL als Rotationsachse), wobei im Bereich der ersten Biegelinie BL bevorzugt eine plastische Verformung des Materials der Schaltungsträgerplatte 100, vorzugsweise der genannten drei Schichten 110, 120, 130, eintritt, so dass nach einem Entfernen von für das Biegen 210 genutzten externen Kräften (aufgebracht z.B. durch ein Biegewerkzeug) die Schaltungsträgerplatte 100 in der gebogenen, nichtebenen Konfiguration verbleibt.

Hierzu wird beispielhaft auf die Figuren 3A, 3B verwiesen, die ein Biegewerkzeug 300 zum Biegen, vorliegend Gesenkbiegen, zusammen mit der Schaltungsträgerplatte 100 zeigen. Das Biegewerkzeug 300 weist einen Stempel 302 und eine Matrize 304 mit i.w. V-förmiger Öffnung auf, wobei u.a. ein Öffnungswinkel der V-förmigen Öffnung (und/oder eine Geometrie des Stempels 302) in Abhängigkeit eines gewünschten Biegewinkels α (Fig. 3B) gewählt ist. Für das Biegen 210 (Fig. 4A) wird der Stempel 302 ausgehend von der in Fig. 3A abgebildeten Ausgangskonfiguration mit ebener Schaltungsträgerplatte 100 in Fig. 3A, 3B vertikal nach unten auf die Matrize 304 zu bewegt, wodurch das Material der Schaltungsträgerplatte 100 im Bereich der Biegelinie (senkrecht zur Zeichenebene der Fig. 3A, 3B) plastisch verformt und somit die nichtebene Konfiguration gemäß Fig. 3B erhalten wird.

Bei weiteren bevorzugten Ausführungsformen ist vorgesehen, dass zumindest ein teilweises Bestücken der Schaltungsträgerplatte 100 vor dem Biegen des wenigstens einen ersten Teilbereichs 100_1 erfolgt. Dies bedeutet, dass bei weiteren bevorzugten Ausführungsformen eine bereits zumindest teilweise bestückte Schaltungsträgerplatte 100 gebogen wird, vgl. die bereits auf der Schaltungsträgerplatte 100 in ebener Konfiguration gemäß Fig. 3A angeordneten Komponenten K1, K2.

Figur 4B zeigt hierzu ein Flussdiagram, wobei Schritt 200 das Bereitstellen der (vorzugsweise ebenen) Schaltungsträgerplatte 100 aufweist, Schritt 205 das zumindest teilweise Bestücken der Schaltungsträgerplatte 100 vor dem Biegen 210. Optional kann auch nach dem Biegen 210 ein zumindest teilweise Bestücken der dann gebogenen Schaltungsträgerplatte 100 (Fig. 3B) erfolgen, vgl. Schritt 215 aus Fig. 4B.

Bei weiteren bevorzugten Ausführungsformen ist vorgesehen, dass das Bestücken 205, 215 wenigstens eines der folgenden Elemente aufweist: a) Setzen von wenigstens einer Komponente K1, K2 (Fig. 2, 3A), insbesondere wenigstens eines elektrischen oder elektronischen Bauteils, b) Löten von wenigstens einer Komponente K1, K2, insbesondere wenigstens eines elektrischen oder elektronischen Bauteils, auf die metallische Funktionsschicht 130 (Fig. 1) bzw. ihre Oberfläche 130a.
Alternativ oder ergänzend kann das Setzen und/oder Löten gemäß weiteren bevorzugten Ausführungsformen auch auf mechanische Bauteile wie Kühlkörper, Abstandsbolzen, Steckverbinder bzw. elektromechanische Bauteile angewandt werden.

Bei weiteren bevorzugten Ausführungsformen kann das Bereitstellen 200 (Fig. 4A, 4B9 der Schaltungsträgerplatte 100 auch das Bereitstellen einer (bereits) zumindest teilweise bestückten Schaltungsträgerplatte aufweisen. Beispielsweise kann eine noch in ihrer ebenen Konfiguration befindliche Schaltungsträgerplatte 100 mit einer ersten Gruppe von Bauelementen bzw. Komponenten bestückt werden, wobei z.B. auch Lötverfahren wie z.B. Reflow-Löten und dergleichen angewandt werden können. Sodann kann die teilweise bestückte Schaltungsträgerplatte gemäß weiteren bevorzugten Ausführungsformen gebogen werden.

Bei weiteren bevorzugten Ausführungsformen, vgl. Fig. 4C, ist vorgesehen, dass das Verfahren weiter aufweist: Definieren 202 wenigstens eines ersten Bereichs B1 (Fig. 2), der, insbesondere zumindest vor dem Biegen 210 (Fig. 4C) des wenigstens einen ersten Teilbereichs, nicht bestückt, insbesondere frei gelassen, werden soll. D.h., auf dem ersten Bereich B1 werden keine Bauteile gesetzt bzw. verlötet, insbesondere nicht vor dem Biegen 210. Dadurch kann vorteilhaft ein Bereich B1 der Schaltungsträgerplatte angegeben werden, in dem die für das Biegen 210 erforderlichen Kräfte eingeleitet werden können, z.B. mittels des Biegewerkzeugs 300 (Fig. 3A). Bevorzugt werden die für das Biegen erforderlichen Kräfte direkt in die Schaltungsträgerplatte 100 eingeleitet, wobei ein Kraftfluss z.B. von einem entsprechenden Werkzeug 302, 304 in eine Oberfläche 110b (Fig. 1) der Trägerschicht 110 und/oder die Oberfläche 130a der metallischen Funktionsschicht 130 erfolgt.

Alternativ oder Ergänzend können bei weiteren bevorzugten Ausführungsformen Biegekräfte auch in ein oder mehrere Seitenflächen des durch die Schaltungsträgerplatte 100 gebildeten Schichtstapels (Fig. 1) eingeleitet werden.

Weitere Bereiche B2, B3 (Fig. 3A), die außerhalb des genannten ersten Bereichs B1 liegen, können bevorzugt bereits vor dem Biegen 210 bestückt werden.

Die Schritte 200, 205 der Fig. 4C entsprechen den Schritten 200, 205 von Fig. 4B.

Bei weiteren bevorzugten Ausführungsformen ist vorgesehen, dass das Biegen 210 so erfolgt, dass - bezogen auf die metallische Funktionsschicht 130 (Fig. 3A) - a) der erste Teilbereich 100_1 einen Winkel α ("Biegewinkel") kleiner 180 Grad mit dem zweiten Teilbereich 100_2 einschließt, mithin sich entsprechende Oberflächenbereiche des ersten Teilbereichs 100_1 und des zweiten Teilbereichs 100_2 der metallischen Funktionsschicht 130 einander annähern. Dies ist beispielhaft in Fig. 3B gezeigt.

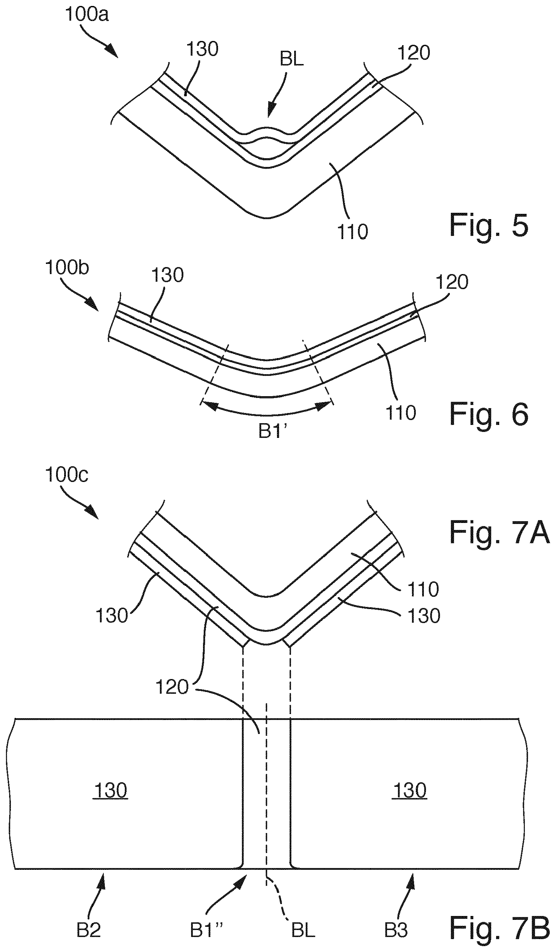

Bei weiteren bevorzugten Ausführungsformen ist vorgesehen, dass das Biegen 210 so erfolgt, dass - bezogen auf die metallische Funktionsschicht 130 (Fig. 3A) - b) der erste Teilbereich 100_1 einen Biegewinkel α größer 180 Grad mit dem zweiten Teilbereich 100_2 einschließt, mithin sich entsprechende Oberflächenbereiche des ersten Teilbereichs 100_1 und des zweiten Teilbereichs 100_2 der metallischen Funktionsschicht 130 bezüglich des Biegewinkels voneinander entfernen. Dies ist beispielhaft anhand der Schaltungsträgerplatte 100c gemäß Fig. 7A gezeigt.

Bei weiteren bevorzugten Ausführungsformen ist vorgesehen, dass die metallische Funktionsschicht 130 im Bereich der ersten Biegelinie BL zumindest teilweise entfernt ist, vgl. Bezugszeichen B1" der Draufsicht gemäß Figur 7B. Dies kann bei weiteren bevorzugten Ausführungsformen beispielsweise bei dem Bereitstellen 200 (Fig. 4A) der Schaltungsträgerplatte 100 und/oder einem ggf. vorangehenden Schritt des Strukturierens der metallischen Funktionsschicht 130 erfolgen.

Bei weiteren bevorzugten Ausführungsformen ist vorgesehen, dass das Biegen 210 (Fig. 4A) bei Normaltemperatur bzw. Raumtemperatur ausgeführt wird. Dies ist aufgrund der vergleichsweise guten plastischen Verformbarkeit der metallischen Trägerschicht 110 effizient möglich.

Bei weiteren bevorzugten Ausführungsformen ist vorgesehen, dass das Biegen 210 mittels Freibiegen ausgeführt wird. Bei weiteren bevorzugten Ausführungsformen ist vorgesehen, dass das Biegen 210 mittels Gesenkbiegen (s. Fig. 3A, 3B) bzw. Abkanten ausgeführt wird.

Figur 5 zeigt schematisch eine Seitenansicht einer Schaltungsträgerplatte 100a gemäß weiteren bevorzugten Ausführungsformen. Dargestellt ist eine bereits gebogene Konfiguration mit einem Biegewinkel α < 180 °. Es ist erkennbar, dass sich vorliegend die metallische Funktionsschicht 130 im Bereich der Biegelinie BL von der dielektrischen Schicht 120 abgelöst hat, was indiziell sein kann für einen zu gering gewählten Biegeradius.

Daher wird bei weiteren bevorzugten Ausführungsformen der Biegeradius bevorzugt größer als ein vorgebbarer Mindestwert gewählt, der beispielsweise für eine gegebene Materialkombination und Schichtstapelgeometrie der Schaltungsträgerplatte 100 (Fig. 1) rechnerisch, z.B. mittels Simulation, und/oder experimentell ermittelbar ist. Dadurch kann sichergestellt werden, dass der Schichtstapel der Schaltungsträgerplatte auch im Biegebereich B1', vgl. die Konfiguration 100b gemäß Fig. 6, seinen Schichtaufbau beibehält. Bei weiteren bevorzugten Ausführungsformen kann der Biegeradius beispielsweise durch Vorgabe einer entsprechenden Geometrie des Stempels 302 (Fig. 3A) und/oder der Matrize 304 eingestellt werden.

Bei weiteren bevorzugten Ausführungsformen, vgl. das Flussidagramm aus Figur 4D und die Seitenansicht aus Fig. 8, ist vorgesehen, dass mehr als ein Teilbereich 100_1, 100_3 gegenüber wenigstens einem anderen Teilbereich 100_2 der Schaltungsträgerplatte 100d gebogen ist. Dementsprechend ist bei weiteren bevorzugten Ausführungsformen vorgesehen, dass das Biegen weiter aufweist: Biegen 210b (Fig. 4D) wenigstens eines dritten Teilbereichs 100_3 der Schaltungsträgerplatte 100d (Fig. 8), insbesondere entlang einer zweiten Biegelinie relativ zu dem ersten Teilbereich 100_1 und/oder zu dem wenigstens einen weiteren Teilbereich 100_2 der Schaltungsträgerplatte 100d. Dadurch sind noch weitere Freiheitsgrade zur Bereitstellung monolithischer nichtebener Schaltungsträgerplatten 100d gegeben. Der Schritt 210a aus Fig. 4D entspricht beispielsweise dem Schritt 210 aus Fig. 4A. Optional kann auch wenigstens ein weiterer Schritt 210c des Biegens (z.B. noch eines weiteren Teilbereichs) erfolgen. Bei weiteren bevorzugten Ausführungsformen können die Schritte 210a, 210b, 210c auch in einer anderen als der vorliegend beispielhaft genannten Reihenfolge ausgeführt werden.

Vorliegend ist die Schaltungsträgerplatte 100d in zwei Biegebereichen BB1, BB2 gebogen (Verlauf der zugehörigen Biegelinien i.w. senkrecht zur Zeichenebene der Fig. 8 und i.w. parallel zueinander), so dass die strukturierte und z.B. zumindest teilweise bestückte metallische Funktionsschicht 130 eine i.w. konvexe Außenoberfläche 130a aufweist. Auf allen drei Teilbereichen 100_1, 100_2, 100_3 können bereits vor dem Biegen 210a, 210b (Fig. 4D) Komponenten bzw. Bauelemente K1', K2', K3' angeordnet worden sein.

Bei weiteren bevorzugten Ausführungsformen ist vorgesehen, dass die zweite Biegelinie parallel zu der ersten Biegelinie ist, wodurch sich z.B. i.w. C-förmige (s. Fig. 8) bzw. U-förmige bzw. Z-förmige nichtebene Schaltungsträgerplatten bereitstellen lassen.

Bei weiteren bevorzugten Ausführungsformen kann beispielsweise auch eine Form für eine nichtebene Schaltungsträgerplatte derart vorgesehen sein, bei der der Winkel α - entsprechend der Festlegung in Fig. 3B - größer als 90° und kleiner als 180° ist.
Bei weiteren bevorzugten Ausführungsformen kann beispielsweise auch eine Z-Form für eine nichtebene Schaltungsträgerplatte derart vorgesehen sein, bei der die beiden Teilbereiche 100_1 und 100_3 (Fig. 8) parallel zueinander sind, wobei insbesondere der dazwischenliegende Teilbereich 100_2 z.B. jeweils senkrecht zu den angrenzenden Teilbereichen 100_1, 100_3 ist. Beispielsweise kann auch ein Winkel α gemäß Fig. 3B zwischen dem ersten Teilbereich 100_1 und dem zweiten Teilbereich 100_2 90° betragen, und ein Winkel α gemäß Fig. 3B zwischen dem zweiten Teilbereich 100_2 und dem dritten Teilbereich 100_3 kann 270° betragen.

Auch bei den C- bzw. U-förmigen Ausführungen können die Teilbereiche 100_1 und 100_3 parallel zueinander sein, wobei z.B. ein Winkel α gemäß Fig. 3B zwischen dem ersten Teilbereich 100_1 und dem zweiten Teilbereich 100_2 90° beträgt und wobei ein Winkel α gemäß Fig. 3B zwischen dem zweiten Teilbereich 100_2 und dem dritten Teilbereich 100_3 ebenfalls 90° beträgt.

In Fig.8 ist die Bestückung K1', K2', K3' beispielhaft auf der konvexen Außenoberfläche angeordnet. Bei weiteren bevorzugten Ausführungsformen (nicht gezeigt) kann dies aber auch eine konkave Innenoberfläche sein.

Bei weiteren bevorzugten Ausführungsformen können sich die Bereiche, die an die beiden Biegelinien BL1, BL2 (Fig. 9) angrenzen, und die nicht bestückt sind, auch überschneiden, s. auch in Fig. 2 den Bereich B1 zur ersten Biegelinie BL und einen äquivalenten Bereich (nicht in Fig. 2 gezeigt) zu einer optionalen zweiten Biegelinie.

Bei weiteren bevorzugten Ausführungsformen ist vorgesehen, dass die zweite Biegelinie BL2, vgl. die Draufsicht auf die Schaltungsträgerplatte 100e gemäß Figur 9, nicht parallel ist zu der ersten Biegelinie BL1, wodurch sich noch weitere Ausgestaltungen nichtebener Schaltungsträgerplatten bereitstellen lassen.

Weitere bevorzugte Ausführungsformen beziehen sich auf eine Verwendung wenigstens einer Schaltungsträgerplatte gemäß den Ausführungsformen zur Halterung und/oder elektrischen Verbindung und/oder Entwärmung wenigstens eines Halbleiterbauelements, insbesondere eines optoelektronischen Bauelements, weiter insbesondere einer Leuchtdiode oder Laserdiode.

Die Verwendung der gebogenen Schaltungsträgerplatte gemäß den Ausführungsformen zusammen mit optoelektronischen Bauelementen ist besonders vorteilhaft, da eine resultierende Abstrahlcharakteristik einer Vorrichtung, die eine gebogene Schaltungsträgerplatte und z.B. mehrere auf der gebogenen Schaltungsträgerplatte angeordnete Leuchtdioden aufweist, durch den Biegewinkel und/oder die Positionierung der Leuchtdioden auf einem entsprechenden Teilbereich 100_1, 100_2, 100_3 der Schaltungsträgerplatte beeinflusst werden kann.

Darüberhinaus weist die Schaltungsträgerplatte gemäß den Ausführungsformen eine vergleichsweise große Stabilität aufgrund der metallischen Trägerschicht 110 auf, die auch "freitragende Konstruktionen" ermöglicht, bei denen zumindest manche Teilbereiche der Schaltungsträgerplatte nicht selbst auf einem Trägerelement befestigt sein müssen. Des weiteren ist durch die metallische Trägerschicht 110 eine gute Wärmeleitung auch innerhalb einer Ebene der Schaltungsträgerplatte gegeben.

Bei weiteren bevorzugten Ausführungsformen können auf der Schaltungsträgerplatte 100 (Fig. 1) auch ein oder mehrere Leiterbahnen mit Anschlussflächen (nicht gezeigt) vorgesehen sein, und an diese Anschlussfläche(n) kann z.B. eine zweite Schaltungsträgerplatte ("Platine") (ebenfalls nicht gezeigt) mit der Schaltungsträgerplatte 100 gemäß bevorzugten Ausführungsformen kontaktiert werden. Weiter bevorzugt kann es sich bei der zweiten Schaltungsträgerplatte bzw. Platine um eine konventionelle Leiterplatte handeln (bei noch weiteren Ausführungsformen jedoch auch um eine weitere Schaltungsträgerplatte 100 gemäß dem Prinzip der vorliegenden Ausführungsformen).

Bei weiteren bevorzugten Ausführungsformen ist vorgesehen, dass die konventionelle Leiterplatte mittels der vorstehend genannten Anschlussflächen mit der Schaltungsträgerplatte 100 verbunden wird, insbesondere elektrisch leitend, z.B. mittels Löten. Eine mechanische Befestigung der konventionellen Leiterplatte an der Schaltungsträgerplatte 100 kann bevorzugt unter Verwendung bekannter Techniken vorgenommen werden, insbesondere auch unter Nutzung des Bereichs B1. Damit kann beispielsweise auch der Bereich B1 (Fig. 2) der Schaltungsträgerplatte 100 genutzt werden, z.B. für eine bzw. die elektronische Schaltung, der (zunächst) für das Biegen 210 (Fig. 4A) der Schaltungsträgerplatte 100 frei gehalten werden musste. Mit anderen Worten kann insbesondere auch in dem für das Biegen 210 (Fig. 4A) zunächst freizuhaltenden Bereich B1 nach dem Biegen eine elektrische Kontaktierung und/oder mechanische Halterung weiterer Schaltungsträgerplatten an der gebogenen Schaltungsträgerplatte 100 erfolgen.

## Patentansprüche

1. Verfahren zum Bearbeiten einer Schaltungsträgerplatte (100; 100a; 100b; 100c; 100d; 100e), aufweisend die folgenden Schritte: Bereitstellen (200) einer Schaltungsträgerplatte (100; 100a; 100b; 100c; 100d; 100e), die eine metallische Trägerschicht (110), eine auf einer ersten Oberfläche (110a) der metallischen Trägerschicht (110) angeordnete dielektrische Schicht (120) und eine zumindest bereichsweise auf einer ersten Oberfläche (120a) der dielektrischen Schicht (120) angeordnete metallische Funktionsschicht (130) aufweist, Biegen (210) wenigstens eines ersten Teilbereichs (100_1) der Schaltungsträgerplatte (100; 100a; 100b; 100c; 100d; 100e), insbesondere entlang einer ersten Biegelinie (BL; BL1) relativ zu wenigstens einem weiteren Teilbereich (100_2) der Schaltungsträgerplatte (100; 100a; 100b; 100c; 100d; 100e).

2. Verfahren nach Anspruch 1, weiter aufweisend:
zumindest teilweises Bestücken (205) der Schaltungsträgerplatte (100; 100a; 100b; 100c; 100d; 100e) vor dem Biegen (210) des wenigstens einen ersten Teilbereichs (100a).

3. Verfahren nach wenigstens einem der vorstehenden Ansprüche, weiter aufweisend: zumindest teilweises Bestücken (215) der Schaltungsträgerplatte (100; 100a; 100b; 100c; 100d; 100e) nach dem Biegen (210) des wenigstens einen ersten Teilbereichs (100a).

4. Verfahren nach wenigstens einem der vorstehenden Ansprüche, weiter aufweisend: Definieren (202) wenigstens eines ersten Bereichs (B1; B1'), der, insbesondere zumindest vor dem Biegen (210) des wenigstens einen ersten Teilbereichs (100a), nicht bestückt (205), insbesondere frei gelassen, werden soll.

5. Verfahren nach wenigstens einem der vorstehenden Ansprüche, wobei das Biegen (210) so erfolgt, dass, bezogen auf die metallische Funktionsschicht (130), a) der erste Teilbereich (100_1) einen Winkel (α) kleiner 180 Grad mit dem zweiten Teilbereich (100_2) einschließt, oder b) der erste Teilbereich (100_1) einen Winkel (α) größer 180 Grad mit dem zweiten Teilbereich (100_2) einschließt.

6. Verfahren nach wenigstens einem der vorstehenden Ansprüche, wobei das Biegen (210) bei Normaltemperatur bzw. Raumtemperatur ausgeführt wird.

7. Verfahren nach wenigstens einem der vorstehenden Ansprüche, wobei die metallische Trägerschicht (110) ein Nichteisenmetall oder eine Nichteisenmetall-Legierung aufweist, insbesondere Aluminium.

8. Verfahren nach wenigstens einem der vorstehenden Ansprüche, wobei die metallische Funktionsschicht (130) Kupfer aufweist, insbesondere Walzkupfer.

9. Verfahren nach wenigstens einem der vorstehenden Ansprüche, wobei das Biegen (210) weiter aufweist:
Biegen (210b) wenigstens eines dritten Teilbereichs (100_3) der Schaltungsträgerplatte (100; 100a; 100b; 100c; 100d; 100e), insbesondere entlang einer zweiten Biegelinie (BL2) relativ zu dem ersten Teilbereich (100_1) und/oder zu dem wenigstens einen weiteren Teilbereich (100_2) der Schaltungsträgerplatte (100; 100a; 100b; 100c; 100d; 100e).

10. Schaltungsträgerplatte (100; 100a; 100b; 100c; 100d; 100e) mit einer metallischen Trägerschicht (110), einer auf einer ersten Oberfläche (110a) der metallischen Trägerschicht (110) angeordneten dielektrischen Schicht (120), und einer zumindest bereichsweise auf einer ersten Oberfläche (120a) der dielektrischen Schicht (120) angeordneten metallischen Funktionsschicht (130), wobei wenigstens ein erster Teilbereich (100_1) der Schaltungsträgerplatte (100; 100a; 100b; 100c; 100d; 100e) gebogen ist, insbesondere relativ zu wenigstens einem weiteren Teilbereich (100_2) der Schaltungsträgerplatte (100; 100a; 100b; 100c; 100d; 100e) entlang einer ersten Biegelinie (B1) gebogen.

11. Schaltungsträgerplatte (100; 100a; 100b; 100c; 100d; 100e) nach Anspruch 10, wobei die metallische Trägerschicht (110) ein Nichteisenmetall oder eine Nichteisenmetall-Legierung aufweist, insbesondere Aluminium, und/oder wobei die metallische Funktionsschicht (130) Kupfer aufweist, insbesondere Walzkupfer.

12. Schaltungsträgerplatte (100; 100a; 100b; 100c; 100d; 100e) nach wenigstens einem der Ansprüche 10 bis 11, wobei mehr als ein Teilbereich (100_1, 100_3) gegenüber wenigstens einem anderen Teilbereich (100_2) der Schaltungsträgerplatte (100; 100a; 100b; 100c; 100d; 100e) gebogen ist.

13. Schaltungsträgerplatte (100; 100a; 100b; 100c; 100d; 100e) nach wenigstens einem der Ansprüche 10 bis 12, wobei die metallische Funktionsschicht (130) im Bereich der ersten Biegelinie (BL1) zumindest teilweise entfernt ist.

14. Verwendung wenigstens einer Schaltungsträgerplatte (100; 100a; 100b; 100c; 100d; 100e) nach wenigstens einem der Ansprüche 10 bis 13 zur Halterung und/oder elektrischen Verbindung und/oder Entwärmung wenigstens eines Halbleiterbauelements (K1), insbesondere eines optoelektronischen Bauelements, weiter insbesondere einer Leuchtdiode oder Laserdiode.
